(19) **Europäisches Patentamt**
**European Patent Office**
**Office européen des brevets**

(11) **EP 1 788 399 A2**

(12) **EUROPÄISCHE PATENTANMELDUNG**

(43) Veröffentlichungstag:
**23.05.2007 Patentblatt 2007/21**

(51) Int Cl.:
***G01R 23/173*** *(2006.01)*

(21) Anmeldenummer: **07004367.4**

(22) Anmeldetag: **30.03.2005**

(84) Benannte Vertragsstaaten:
**DE FR GB**

(30) Priorität: **26.04.2004   DE 102004020278**

(62) Dokumentnummer(n) der früheren Anmeldung(en) nach Art. 76 EPÜ:
**05006952.5 / 1 592 131**

(71) Anmelder: **Rohde & Schwarz GmbH & Co. KG**
**81671 München (DE)**

(72) Erfinder: **Wanierke, Otmar**
**81539 München (DE)**

(74) Vertreter: **Körfer, Thomas et al**
**Mitscherlich & Partner**
**Patent- und Rechtsanwälte**
**Sonnenstrasse 33**
**80331 München (DE)**

Bemerkungen:
Diese Anmeldung ist am 02-03-2007 als Teilanmeldung zu der unter INID-Kode 62 erwähnten Anmeldung eingereicht worden.

(54) **Spektrumanalysator mit hoher Geschwindigkeit und gleichzeitig hoher Auflösung**

(57)     Ein Spektrumanalysator (1), der nach dem Überlagerungsprinzip arbeitet, besteht aus einem Sollfrequenzgeber (18, 32), einem lokalen Frequenzoszillator (21), einem Mischer (20), einem Auflösungsfilter (2; 2'; 2''; 2'''; 2''''; 2''''') und einem Detektor (13, 14, 15, 16). Das Auflösungsfilter (2; 2'; 2''; 2'''; 2''''; 2''''') umfaßt ein Vorfilter (22; 24, 26) und einen nachgeschalteten Korrelator (23).

Fig. 2

**Beschreibung**

Die Erfindung betrifft einen Spektrumanalysator mit hoher Geschwindigkeit und gleichzeitig hoher Auflösung.

Spektrumanalysatoren mit hoher Geschwindigkeit und gleichzeitig hoher Auflösung wenden nach Christoph Rauscher: "Grundlagen der Spektrumsanalyse", Rohde und Schwarz GmbH & Co. KG, München, 2000, Seite 19 bis 28, vielfach das Verfahren der FFT-Analyse (Fast Fourier Transformation) an. Aufgrund der notwendigen Analog-Digital-Wandelung des Meßsignals für die Durchführung der FFT-Analyse ist die Bandbreite des zu analysierenden Eingangsfrequenzbereich durch die maximale Abtastfrequenz der eingesetzten Analog-Digital-Wandler auf eine maximale Bandbreite $B_{MAX}$ eingeschränkt (Nyquist-Kriterium). Man ist in einem solchen Fall gezwungen, den gesamten Eingangsfrequenzbereich in mehrere Teilefrequenzbereiche zu unterteilen, die nacheinander jeweils über einen Mischer in einen Frequenzbereich umgesetzt werden, dessen Bandbreite innerhalb der maximalen Bandbreite $B_{MAX}$ des Analog-Digital-Wandlers liegt. Nachteilig an dieser sequenziellen Durchführung der FFT-Analyse der einzelnen Teilfrequenzbänder ist die endliche Einschwinggeschwindigkeit des Mischers auf die für die Frequenzumsetzung der einzelnen Teilefrequenzbänder erforderlichen Mischerfrequenzen. Um die einzelnen Teilfrequenzbänder mit einer bestimmten Frequenzgenauigkeit $B_A$ im Rahmen der Spektrumanalyse zu analysieren, entstehen Wartezeiten zwischen den Vermessungen zweier benachbarter Teilfrequenzbänder. Diese Wartezeit erhöht sich bei höherer Frequenzauflösung $B_A$ der Spektrumsanalyse.

Derartige Wartezeiten entfallen bei einem Spektrumanalysator nach dem Überlagerungsprinzip, wie er aus Christoph Rauscher: " Grundlagen der Spektrumsanalyse", Rohde und Schwarz GmbH & Co. KG, München, 2000, Seite 29 bis 32, bekannt ist. Hierbei wird ein Meßsignal mit Hilfe eines Mischers und eines Lokaloszillators (LO) auf eine Zwischenfrequenz umgesetzt. Ist die Frequenz des Lokaloszillators abstimmbar, so kann durch Variation der LO-Frequenz der gesamte Eingangsfrequenzbereich auf eine konstante Zwischenfrequenz umgesetzt werden. Auf diese Weise ist es möglich, den gesamten Eingangsfrequenzbereich durch ein Auflösungsfilter (Resolutions-Filter) mit einer vorgegebenen Bandbreite, dessen Mittenfrequenz exakt auf der konstanten Zwischenfrequenz liegt, zu fahren (sweepen). Das Abstimmen der Mischerfrequenz erfolgt nicht sprunghaft wie beim Verfahren der FFT-Analyse, sondern kontinuierlich entlang einer Rampe mit einer konstanten Sweep-Geschwindigkeit $v_s$. Zum Durchstimmen des Eingangsfrequenzbereiches benötigt der Spektrumanalysator nach dem Überlagerungsprinzip folglich eine Sweepzeit $t_s$, während Einschwingzeiten des Mischers entfallen.

Bei geforderter Auflösebandbreite $B_A$ ist die in einem Spektrumanalysator nach den Überlagerungsprinzip realisierbare Sweepgeschwindigkeit $v_s$ begrenzt, da sich beide Größen gegenseitig eingrenzen. Zwischen der geforderten Auflösebandbreite $B_A$ und der realisierbaren Sweepgeschwindigkeit $v_s$ besteht ein quadratischer Zusammenhang, der durch den inversen K-Faktor als Proportionalitätsfaktor beschrieben ist. Während bei analogen Auflösungsfiltern lediglich K-Faktoren, die größer als 2,5 sind, realisierbar sind, sind bei digitalen Auflösungsfiltern, wie in der DE 101 05 258 A1 gezeigt ist, kleinere K-Faktoren möglich.

Da die zeitdiskrete Impulsantwort des Auflösungsfilters der DE 101 05 258 A1 einen komplexen Term $(\exp(-jC_3 {}^* t^2)$ aufweist, entstehen, falls das Auflösungsfilter von einem Meßsignal mit einem charakteristischen Frequenzspektrum angeregt wird, Schwingungen. Diese Schwingungen müssen durch den Dämpfungsterm $(\exp(C_2 {}^* t^2))$ der zeitdiskreten Impulsantwort des Auflösungfilters effizient gedämpft werden. Da die Dämpfunigskonstante C2 des Dämpfungsterms $(C2 = \pi^2 {}^* B_{RES}{}^2/(2+1n(2)))$ indirekt proportional zum Quadrat der Bandbreite $B_{RES}$ des Auflösungfilters ist, muss das Auflösungsfilter im Hinblick auf eine effiziente Dämpfung von auftretenden Schwingungen möglichst breitbandig ausgelegt werden, wodurch sich die Auflösung des Spektrumanalysators deutlich verschlechtert.

Der Erfindung liegt deshalb die Aufgabe zugrunde, einen Spektrumanalysator nach den Überlagerungsprinzip derart weiterzuentwickeln, dass einerseits die Bandbreite $B_{RES}$ des Auflösungfilters im Hinblick auf eine hohe Auflösung des Spektrumanalysators möglichst optimiert ist und gleichzeitig bei maximal realisierter Auflösung $B_A$ des Auflösungsfilters eine möglichst hohe Sweepgeschwindigkeit $v_s$ verwirklicht wird, und ein entsprechendes Auflösungsfilter anzugeben.

Die Aufgabe der Erfindung wird durch einen Spektrumanalysator mit den kennzeichnenden Merkmalen in Verbindung mit den gattungsbildenden Merkmalen des Anspruchs 1 und durch ein Auflösungsfilter nach Anspruch 16 gelöst.

Das Auflösungsfilter des erfindungsgemäßen Spektrumanalysators besteht aus einer Serienschaltung eines Vorfilters und eines Korrelators. Während das Vorfilter eine von der Sweepgeschwindigkeit $v_s$ des Spektrumanalysator unabhängige Impulsantwort h(t) aufweist, ist der Korrelator durch eine Korrekturfunktion g(t) gekennzeichnet, die eine Abhängigkeit von der Sweepgeschwindigkeit $v_s$ des Spektrumanalysators besitzt. Mit der Korrekturfunktion g(t) wird im Korrelator das im Vorfilter vorgefilterte Eingangsignal a(t) am Eingang des Spektrumanalysators gefaltet.

Wie noch gezeigt wird, korrigiert der Korrelator mit seiner Korrekturfunktion g(t) den Einfluss der "Frequenzrampe" der Mischerfrequenz in Übertragungsverhalten des Spektrumanalysators.

Zusätzlich, wie auch noch gezeigt wird, bewirkt die Faltung des im Vorfilter vorgefilterten Eingangsignals a(t) in Auflösungsfilter des erfindungsgemäßen Spektrumanalysators ein Übertragungsverhalten des Auflösungsfilters, dass durch eine reelle Impulsantwort h(t) beschrieben wird. Auf diese Weise werden im Auflösungsfilter keine Schwingungen angeregt.

Schließlich kann durch die erfindungsgemäße Konstellation der Serienschaltung des Vorfilters und des Korrelator des Auflösungsfilter des erfindungsgemäßen Spektrumanalysator, wie auch noch gezeigt wird, die Gegenläufigkeit des Einflusses der Auflösungsbandbreite $B_A$ des Auflösungsfilters und der Sweepgeschwindigkeit $v_s$ des erfindungsgemäßen Spektrumanalysators aufgehoben werden. Somit ist ein minimaler K-Faktor gar nicht mehr anzustreben und der K-Faktor verliert bei einem derart realisierten Auflösungsfilter vollkommen seine Bedeutung bei der Optimierung der Auflösungsbandbreite $B_A$ und der Sweep-Geschwindigkeit $v_s$. Anzustreben ist vielmehr, die Auflösungsbandbreite $B_A$ des Auflösungsfilter möglichst bandbreitig zu gestalten, was durch die Abtastrate des integrierten Analog-Digital-Wandlers und der maximal realisierbaren Bandbreite $B_{RES}$ des analogen Vorfilters begrenzt ist.

Vorteilhafte Ausgestaltungen der Erfindung sind in den abhängigen Ansprüchen angegeben.

Im Hinblick auf eine höhere Digitalisierung des Auflösungfilters und der damit verbundenen Vorteile - z.B. höherer Signal-Rausch-Abstand, vereinfachter Aufbau durch höhere Integration - kann das Auflösungfilter in einer zweiten Ausführungsform des erfindungsgemäßen Spektrumanalysators in eine analoge Komponente zur analogen Vorfilterung im Zwischenfrequenzbereich und eine digitale Komponente mit nicht-rekursiver Filterstruktur (FIR-Filter) zur digitalen Nachtfilterung im Zwischenfrequenz- und I-Q-Mischungsbereich zerlegt werden. Auf diese Weise kann die digitale Komponente zur digitalen Nachtfilterung mit dem Korrelator integriert werden.

Neben der quasi-parallelen Durchführung der Vorfilterung und Faltung des Auflösungfilters in Echtzeit in der ersten und zweiten Ausführungsform des erfindungsgemäßen Spektrumanalysators werden in einer dritten Ausführungsform des erfindungsgemäßen Spektrumanalysators die im Vorfilter vorgefilterten Abtastwerte der Eingangsfunktion vom Vorfilter in Echtzeit in einen digitalen Speicher abgespeichert, aus dem sie der Korrelator zur zeitversetzten Faltung asynchron ausliest. Somit kann die Faltung von der Vorfilterung vollkommen zeitlich entkoppelt im Offline-Betrieb durchgeführt werden.

In einer vierten Ausführungsform des erfindungsgemäßen Spektrumanalysators wird der Korrelator anstelle einer zeitaufwändigen Berechnung der Faltung in Zeitbereich mittels Multiplikation im Frequenzbereich unter Anwendung von Algorithmen der Fast-Fourier-Transformation realisiert.

Während in der ersten bis vierten Ausführungsform des erfindungsgemäßen Spektrumanalysators einzig der gesamte Eingangsfrequenzbereich des zu analysierenden Meßsignals vermessen wird, werden in einer fünften und sechsten Ausführungsform des erfindungsgemäßen Spektrumanalysators ein oder mehrere Teilfrequenzbereiche des gesamten Eingangsfrequenzbereichs zusätzlich zum oder ohne den gesamten Eingangsfrequenzbereich gleichzeitig jeweils mit unterschiedlicher Auflösebandbreiten vermessen und in mehreren Fenstern einer Anzeige dargestellt. Hierzu wird für jeden darzustellenden Frequenzbereich jeweils ein Vorfilter mit einer zur gewünschten Auflösung des Frequenzbereichs korrelierenden Bandbreite in Serie oder parallel geschaltet und das in den einzelnen Vorfiltern mit unterschiedlichen Bandbreiten vorgefilterte Eingangsignal jeweils über einen Analog-Digital-Wandler mit einer zur Bandbreite des jeweiligen Vorfilters passenden Abtastfrequenz abgetastet und jeweils einem Korrelator zur anschließenden Faltung zugeführt. Die einzelnen Korrelatoren können aufgrund der ihnen zugeführten Signale, die mit unterschiedlicher Abtastfrequenz abgetastet sind, unterschiedlich aufwändig realisiert sein.

Schließlich wird in einer siebten Ausführungsform des erfindungsgemäßen Spektrumanalysators anstelle eines Sägezahngenerators ein Funktionsgenerator zur Erzeugung einer dreiecksförmigen Zeitfunktion eingesetzt, dessen ansteigende und abfallende Frequenzrampe eine unterschiedliche Steigung aufweist. Auf diese Weise kann der gesamte Eingangsfrequenzbereich des zu analysierenden Meßsignals in der Phase der ansteigenden und der abfallende Frequenzrampe mit jeweils unterschiedlichen minimalen Auflösebandbreiten aufgenommen werden.

Die Ausführungsformen des erfindungsgemäßen Spektrumanalysators werden nachfolgend unter Bezugnahme auf die Zeichnung näher erläutert. In der Zeichnung zeigen:

Fig. 1    ein Blockschaltbild eine Spektrumanalysators nach den Überlagerungsprinzip,

Fig. 2    ein Blockschaltbild eines Auflösungfilters einer ersten Ausführungsform des erfindungsgemäßen Spektrumanalysators,

Fig. 3    ein Blockschaltbild eines Auflösungfilters einer zweiten Ausführungsform des erfindungsgemäßen Spektrumanalysators,

Fig. 4    ein Blockschaltbild eines Auflösungfilters einer dritten Ausführungsform des erfindungsgemäßen Spektrumanalysators,

Fig. 5    ein Blockschaltbild eines Auflösungfilters einer vierten Ausführungsform des erfindungsgemäßen Spektrumanalysators,

Fig. 6    ein Blockschaltbild eines Auflösungfilters einer fünften Ausführungsform des erfindungsgemäßen Spektrumanalysators,

Fig. 7    ein Blockschaltbild eines Auflösungfilters einer sechsten Ausführungsform des erfindungsgemäßen Spektrumanalysators und

Fig. 8    ein Blockschaltbild einer siebten Ausführungsform des erfindungsgemäßen Spektrumanalysators.

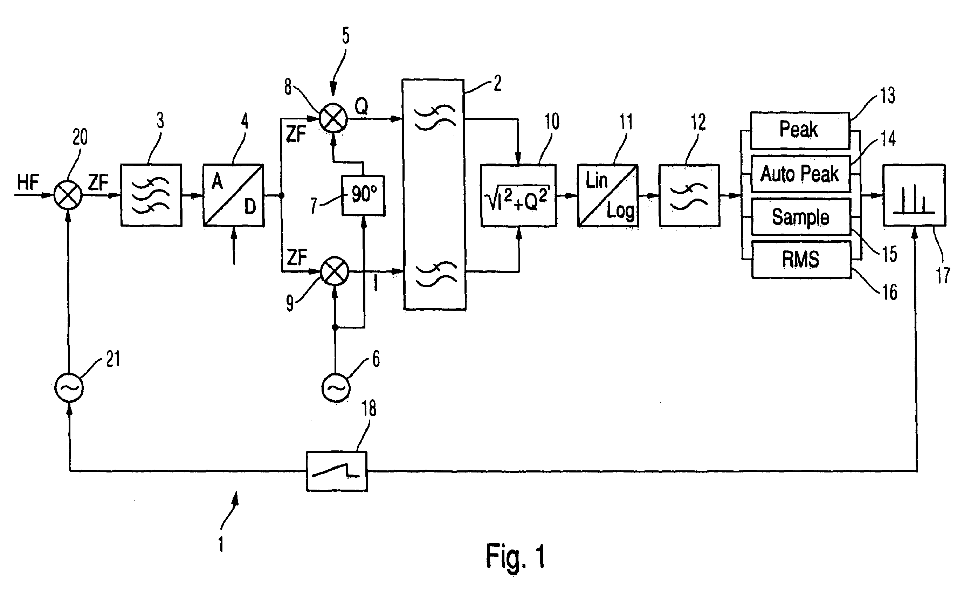

Fig. 1 zeigt einen Spektrumanalysator 1, bei welchem das erfindungsgemäße Auflösungsfilter 2 zum Einsatz kommt, im Überblick.

Das mit HF bezeichnete Hochfrequenzsignal am Eingang des Spektrumanalysators 1 wird mittels des Mischer 20, dem das in einem Frequenzoszillator 21 erzeugte Mischersignal zugeführt wird, in das Zwischenfrequenzsignal ZF umgesetzt. Das Zwischenfrequenzsignal ZF wird in einem Bandpaß 3 gefiltert. An den Bandpaß 3 schließt sich ein Analog-Digital-Wandler 4. an. Anschließend folgt die I/Q-Mischung in einem I/Q-Demodulator 5, der in üblicher Weise aus einem lokalen Oszillator 6 und einem 90 Grad-Phasenschieber 7 zur Erzeugung zweier um 90 Grad phasenverschobener Mischersignale besteht, die zusammen mit dem gefilterten und analog/digital-gewandelten Zwischenfrequenzsignal jeweils einem Mischer 8 des Q-Zweigs und einem Mischer 9 des I-Zweigs zugeführt werden.

Daran schließt sich die digitale Filterung mit den erfindungsgemäßen Auflösungsfilter 2 an. Schließlich erfolgt die Hüllkurvengleichrichtung in einem Hüllkurvengleichrichter 10. Die Logarithmierung erfolgt in einem Logarithmierer 11. Auf den Logarithmierer 11 folgt ein Videofilter 12, in welchem die Videofilterung erfolgt.

Für die Detektion können unterschiedliche Detektoren 13 bis 16, beispielsweise ein Peak-Detektor 13, ein Auto-Peak-Detektor 14, ein Sample-Detektor 15 und ein RMS (Route Mean Square)-Detektor 16 zur Verfügung stehen. Je nach Anforderungen können entweder alle vier Detektoren bei einem Spektrumanalysator 1 mit hoher Performance eingebaut werden, oder es können nur bestimmte Detektoren, z. B. bei spezialisierten Messeaufgaben nur ein einziger Detektor, eingebaut werden. Die Darstellung der detektierten Frequenz-Komponenten erfolgt in einer Anzeige 17.

Die Ansteuerung des lokalen Oszillators 21 und der Anzeige 17 erfolgt z. B. über einen Sägezahngenerator 18.

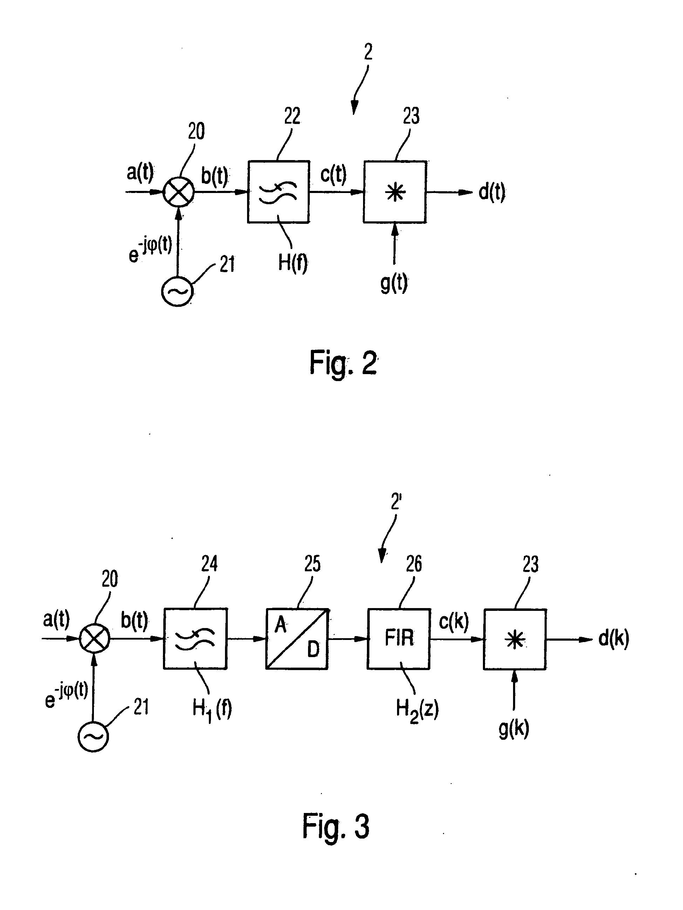

Fig. 2 zeigt ein vereinfachtes Blockschaltbild des Mischers 20, des Frequenzoszillators 21, des Bandpasses 3, des Analog-Digital-Wandlers 4, des I/Q-Demodulators 5 und des Auflösungfilters 2 des Spektrumanalysators 1 aus Fig. 1 als erste Ausführungsform eines erfindungsgemäßen Auflösungfilters 2 des erfindungsgemäßen Spektrumanalysators 1. Hierbei wird der Bandpaß 3, der Analog-Digital-Wandler 4, der I/Q-Demodulator 5 und das Auflösungsfilter 2 näherungsweise durch das Auflösungsfilter 22 mit Tiefpaßcharakteristik modelliert. Das zu analysierende komplexe Hochfrequenz-Eingangsignal a(t) wird einem Mischer 20 zugeführt und durch Multiplikation mit dem Sweep-Signal $e^{-j\varphi(t)}$, das in einem lokalen Oszillators 21 erzeugt wird, in das Basisbandssignal b(t) heruntergemischt. Das Basisbandsignal b(t) wird dem erfindungsgemäßen Auflösungsfilter 2 zugeführt. Dieses erfindungsgemäße Auflösungsfilter 2 besteht aus einem Vorfilter 22 mit der Übertragungsfunktion H(f) und der dazu korrespondierenden Impulsantwort h(t), das das Basisbandssignal b(t) entsprechend seiner Impulsantwort h(t) vorfiltert, und einen nachgeschalteten Korrelator 23, der das vorgefilterte Basisbandssignal c(t) mit einer Korrekturfunktion g(t) faltet. Am Ausgang des Korrelators 23 steht ein Ausgangssignal d(t) an, das aus einer Vorfilterung eines Basisbandsignals b(t) und einer anschließenden Faltung mit der Korrekturfunktion g(t) entsteht.

Im Hinblick auf ein besseres Verständnis des eigentlichen Erfindungsgedankens wird das Übertragungsverhalten des erfindungsgemäßen Auflösungfilters 2 im folgenden im Detail diskutiert:

Da das erfindungsgemäße Auflösungsfilter 2 einzig aus linearen Komponenten - lineares Vorfilter 22 und linearer Korrelator 23 - besteht, kann von einem linearen Gesamtübertragungsverhalten des erfindungsgemäßen Auflösungsfilters 2 ausgegangen werden, so dass in der folgenden linearen Betrachtung alle Übertragungseigenschaften des Auflösungsfilters 2 erfasst werden.

Für die Betrachtung wird gemäß Gleichung (1) ein Eingangssignal a(t) mit einer einzigen festen Frequenz f und einer konstanten Amplitude mit dem Einheitswert 1 ausgegangen. Hierbei wird mit $W=e^{j2\pi}$ eine übliche Abkürzung der Signaltheorie eingeführt.

$$a(t) = e^{j2\pi ft} = W^{ft} \qquad\qquad (1)$$

Das Eingangsignal a(t) wird im Mischer 20 gemäß Gleichung (2) mit dem Sweep-Signal $e^{-j\varphi(t)}$ zu einem Basisbandssignal b(t) gemischt.

$$b(t) = a(t)e^{-j\varphi(t)} \qquad (2)$$

Das Sweep-Signal $e^{-j\varphi(t)}$ enthält ein zeitabhängiges Phasensignal $\varphi(t)$, das gemäß Gleichung (3) von der zeitabhängigen Frequenz $f_M(t)$ abhängig ist.

$$\varphi(t) = 2\pi \frac{\partial f_M(t)/\partial t}{2} t^2 \qquad (3)$$

Die Momentanfrequenz $f_M(t)$ wird im lokalen Oszillator 21 entsprechend dem Ansteuersignal des Sägezahngenerators 18 als linear ansteigende Frequenzrampe erzeugt, deren Zeitfunktion sich entsprechend Gleichung (4) ergibt. Hierbei stellen die Frequenzen $f_A$ und $f_B$ die Grenzen des zu analysierenden Frequenzbereiches, $f_z$ die Zwischenfrequenz des Auflösungsfilters 2 und $t_s$ die Zeitdauer für das Durchfahren - Sweepen - des Frequenzbereiches dar.

$$f_M(t) = f_A + \underbrace{\frac{f_B - f_A}{t_S}}_{=v_S} t - f_z \qquad (4)$$

Hierbei wird berücksichtigt, dass die Zwischenfrequenz $f_z$ des Auflösungfilters 2 niederfrequenter als das Frequenzband des zu vermessenden Meßsignals a(t) ist und das Meßsignal a(t) mit seinem zu vermessenden Frequenzband mittels Mischung im Mischer 20 mit der Mischerfrequenz gemäß Gleichung (4) zur Zwischenfrequenz des Auflösungsfilters 2 umgesetzt wird, die der Mittenfrequenz des als Bandpaß-Filter ausgelegten Auflösungfilters 2 entspricht.
Definiert man gemäß Gleichung (5) die Sweepgeschwindigkeit $V_s$ als die Geschwindigkeit zum Durchfahren des Frequenzbandes $\Delta f$ in der Sweep-Zeit $t_s$, so kann das Phasensignal $\varphi(t)$ aus Gleichung (3) nach Gleichung (6) dargestellt werden.

$$v_S = \Delta f / t_s \quad \text{mit} \quad \Delta f = f_B - f_A \qquad (5)$$

$$\varphi(t) = 2\pi \frac{v_S}{2} t^2 \qquad (6)$$

Unter Anwendung von Gleichung (6) ergibt sich folglich für die Momentanfrequenz $f_M(t)$ des Sweep-Signals $e^{-j\varphi(t)}$ die in Gleichung (7) dargestellte Zeitbeziehung:

$$f_M(t) = \frac{\partial \varphi(t)/\partial t}{2\pi} - f_z = v_S * t - f_z \qquad (7)$$

Die Beziehung in Gleichung (7) kann durch Zeitverschiebung leicht in die Beziehung in Gleichung (4) übergeführt werden.
Die Vorfilterung des Basisbandssignals b(t) im Vorfilter 22 mit der Filterübertragungsfunktion H(f) entspricht gemäß Gleichung (8) einer Faltung des Basisbandssignals b(t) mit der Impulsantwort h(t) des Vorfilters 22.

$$c(t) = \int b(\tau)h(t-\tau)d\tau \qquad (8)$$

Das vorgefilterte Signal c(t) am Ausgang des Vorfilters 22 wird im Korrelator 23 mit der Korrekturfunktion g(t) gefaltet. Die Korrekturfunktion g(t), die gemäß Gleichung (9) von der Sweepgeschwindigkeit $v_s$ des erfindungsgemäßen Spektrumanalysators 1 abhängig ist, kompensiert den verzerrenden Einfluss der Frequenzrampe des Sweep-Signals $e^{-j\varphi(t)}$ auf das zu vermessende Eingangssignal a(t).

$$g(t) = e^{j2\pi\frac{v_s}{2}t^2} = W^{\frac{v_s}{2}t^2} \qquad (9)$$

Das Ausgangssignal d(t) des Auflösungfilters 2 ergibt sich gemäß Gleichung (10):

$$d(t) = \int c(u)g(t-u)du \qquad (10)$$

Durch Einsetzen der Beziehung für das vorgefilterte Signal c(t) aus Gleichung (8) in die Gleichung (10) ergibt sich für das Faltungsergebnis d(t) des Korrelators 23 die in Gleichung (11) dargestellte Beziehung:

$$d(t) = \int\int b(\tau)h(u-\tau)d\tau g(t-u)du \qquad (11)$$

Wird die Beziehung der Phasensignal $\varphi(t)$ aus Gleichung (6) in die Beziehung des Basisbandssignals b(t) in Gleichung (2) eingesetzt und die daraus entstehende neue mathematische Beziehung für das Basisbandssignal b(t) zusammen mit der mathematische Beziehung für das Korrektursignal g(t) aus Gleichung (9) in Gleichung (11) eingesetzt, so ergibt sich für das Ausgangssignal d(t) des Auflösungfilters 2 die in Gleichung (12) dargestellte Beziehung:

$$d(t) = \int\int W^{-\frac{v_s}{2}\tau^2 + f\tau} h(u-\tau) W^{\frac{v_s}{2}(t-u)^2} du d\tau$$
$$= W^{\frac{v_s}{2}t^2} \int\int h(u-\tau) W^{\frac{v_s}{2}(-\tau^2 - 2tu + u^2) + f\tau} du d\tau \qquad (12)$$

Wird nun die neue Variable z=u-$\tau$ in Gleichung (12) eingesetzt, so ergibt sich die in Gleichung (13) dargestellte neue Beziehung für das Ausgangssignal d(t) des Auflösungfilters 2:

$$d(t) = W^{\frac{v_s}{2}t^2} \int\int h(z) W^{\frac{v_s}{2}(-2t(z+\tau) + z^2 + 2z\tau) + f\tau} dz d\tau$$
$$= W^{\frac{v_s}{2}t^2} \int\int h(z) W^{\frac{v_s}{2}z^2} W^{-v_s(tz + t\tau - z\tau) + f\tau} dz d\tau \qquad (13)$$

Substituiert man in der mathematische Beziehung für das Ausgangssignal d(t) des Auflösungfilters 2 die Funktion $h(z)*W^{v_s/2*z^2}$ durch die Hilfsimpulsantwort $h_1(z)$, so erhält man den in Gleichung (14) dargestellte mathematischen Zusammenhang für das Ausgangssignal d(t) des Auflösungfilters 2:

$$d(t) = W^{\frac{v_s}{2}t^2} \iint h_1(z) W^{-v_s z(t-\tau)} dz \, W^{-v_s t\tau + f\tau} d\tau \qquad (14)$$

Ersetzt man weiters die Zeitvariable z in der mathematischen Beziehung des Ausgangssignals d(t) des Auflösungfilters 2 in Gleichung (14) mit der Substitution z=y/v durch eine Momentanfrequenzvariable y, so folgt für das Ausgangssignal d(t) des Auflösungfilters 2 die mathematische Beziehung in Gleichung (15):

$$d(t) = \frac{1}{v_s} W^{v_s/2 \cdot t^2} \iint h_1(y/v_s) W^{-y(t-\tau)} dy \, W^{-v_s t\tau + f\tau} d\tau \qquad (15)$$

Wird schließlich in der mathematischen Beziehung des Ausgangssignals d(t) des Auflösungfilters 2 die Hilfsimpulsantwort $h_1(z)=h_1(y/v_s)$ durch eine weitere Hilfsimpulsantwort $h_2(y)$ ersetzt, so ergibt sich Gleichung (16) für das Ausgangssignal d(t) des Auflösungfilters 2:

$$d(t) = \frac{1}{v_s} W^{v_s/2 \cdot t^2} \iint h_2(y) W^{-y(t-\tau)} dy \, W^{-v_s t\tau + f\tau} d\tau \qquad (16)$$

In Gleichung (16) erkennt man die Berechnungsformel zur Berechnung der Fourier-Transformierten $H_2(t-\tau)$ $= \mathfrak{F}\{h_2(y)\}|_{t-\tau}$, die gemäß Gleichung (17) lautet:

$$H_2(t-\tau) = \mathfrak{F}\{h_2(y)\}|_{t-\tau} = \int h_2(y) * e^{-j2\pi(t-\tau)} dy \qquad (17)$$

Zu erwähnen ist hierbei, dass die Fourier-Transformation vom Frequenzbereich in den Zeitbereich durchgeführt wird, da das Argument der Hilfsimpulsantwort $h_2(y)$ die Frequenzvariable y und das Argument der Fourier-Transformierten $H_2(t-\tau)$ die Zeitvariable t-$\tau$ ist. Durch Einführung der Fourier-Transformierten $H_2(t-\tau)$ in der Beziehung des Ausgangssignals d(t) des Auflösungfilters 2 in Gleichung (17) folgt Gleichung (18):

$$d(t) = \frac{1}{v_s} W^{\frac{v_s}{2}t^2} \int H_2(t-\tau) W^{(f-v_s t)\tau} d\tau \qquad (18)$$

Da in einem Spektrumanalysator die Meßergebnisse im Frequenzbereich dargestellt werden, ist folglich eine mathematische Beziehung für das Ausgangssignal d($f_m$) des Auflösungfilters 2 mit der Messefrequenz $f_m$ als Argument zu ermitteln. Hierzu wird ausgehend von Gleichung (18) die Zeitdifferenz t-$\tau$ durch die neue Hilfsvariable x substituiert, womit sich Gleichung (19) mit dem Ausgangssignal d(t) des Auflösungfilters 2 ergibt.

$$d(t) = \frac{1}{v_S} W^{\frac{v_S t^2}{2}} \int H_2(x) W^{(f-v_S t)(t-x)} dx$$

$$= \frac{1}{v_S} W^{\frac{v_S t^2}{2}} \int H_2(x) W^{ft-fx-v_2 t^2+v_2 tx} dx$$

$$= \frac{1}{v_S} W^{-\frac{v_S t^2}{2}+ft} \int H_2(x) W^{(v_S t-f)x} dx \qquad (19)$$

Gleichung (19) stellt die Beziehung zur Berechnung der inversen Fourier-Transformation aus der Fourier-Transformierten $H_2(x)$ dar. Führt man nun auf der Basis von Gleichung (19) diese inverse Fourier-Transformation auf die Fourier-Transformierte $H_2(x)$ durch, so ergibt sich mit der Hilfsimpulsantwort $h_2(v_S t-f)$ als Ergebnis der inversen Fourier-Transformation die Beziehung für das Ausgangssignal d(t) des Auflösungfilters 2 in Gleichung (20):

$$d(t) = \frac{1}{v_S} W^{-\frac{v_S}{2}t^2+ft^{-1}} F^{-1}(H_2)(v_S t - f)$$

$$= \frac{1}{v_S} W^{-\frac{v_S}{2}t^2+ft} h_2(v_S t - f) \qquad (20)$$

Aus Gleichung (20) ergibt sich für das Ausgangssignal d(t) des Auflösungfilters 2 Gleichung (19), wenn die Hilfsimpulsantwort $h_2(v_S t-f)$ durch die ursprüngliche Hilfsimpulsantwort $h_1((v_S t-f)/v_S)$ wieder resubstituiert wird:

$$d(t) = \frac{1}{v_S} W^{-\frac{v_S}{2}t^2+ft} h_1(t - f/v_S) \qquad (21)$$

Wird die Hilfsimpulsantwort $h_1(t-f/v_S)$ in Gleichung (21) durch die ursprüngliche Impulsantwort

$h(t-f/v_S) * W^{v_S/2*(t-f/v_S)^2}$ wieder resubstituiert und die Abkürzung W wieder aufgelöst, so folgt Gleichung (22) für das Ausgangssignal d(t) des Auflösungfilters 2:

$$d(t) = \frac{1}{v_S} W^{-\frac{v_S}{2}t^2+ft} h(t - f/v_S) W^{\frac{v_S}{2}(t-f/v_S)^2}$$

$$= \frac{1}{v_S} W^{\frac{f^2}{2v_S}} h(t - f/v_S)$$

$$= \frac{1}{v_S} e^{j\pi \frac{f^2}{v_S}} h(t - f/v_S) \qquad (22)$$

Um das Ausgangssignal $d(f_m)$ des Auflösungfilters 2 mit der Messefrequenz $f_m$ als Argument anstelle des Zeitarguments t zu ermitteln, ist der Zusammenhang zwischen der Meßfrequenz $f_m$ und der Zeit t zu ermitteln. Die aktuell mit dem Spektrumanalysator 1 gemessene Meßfrequenz $f_m(t)$ des Meßsignals a(t) ergibt sich gemäß Gleichung (23) aus der Addition der Momentanfrequenz $f_M(t)$ des Sweep-Signals $e^{-j\varphi(t)}$ und der Zwischenfrequenz $f_z$ des Auflösungfilters 2.

$$f_m(t) = f_M(t) + f_Z \qquad (23)$$

Berücksichtigt man die Beziehung der Momentanfrequenz $f_M(t)$ des Sweep-Signals aus Gleichung (7) in Gleichung (23), so erhält man für die aktuelle Meßfrequenz $f_m(t)$ die in Gleichung (24) dargestellte mathematischen Beziehung:

$$f_m(t) = v_S * t \qquad (24)$$

Substituiert man in Gleichung (22) für das Ausgangssignal d(t) des Auflösungfilters 2 das Zeitargument t entsprechend Gleichung (24) durch das Argument $f_m(t)/v_s$, so ergibt sich Gleichung (25) für das Ausgangssignal $d(f_m(t)/v_s)$:

$$d(f_m(t)/v_S) = \frac{1}{v_S} e^{j\pi \frac{f^2}{v_s}} h((f_m(t) - f)/v_S) \qquad (25)$$

Ersetzt man in Gleichung (25) das Ausgangssignal $d(f_m(t))$ durch das Ersatzausgangssignal $d_1(f_m(t))$, so erhält man mit der Beziehung für $d_1(f_m(t))$ in Gleichung (26) einen mathematischen Ausdruck für das Ausgangssignal des Auflösungfilters 2 als Funktion der Messefrequenz $f_m$:

$$d_1(f_m) = \frac{1}{v_S} e^{j\pi \frac{f^2}{v_s}} h((f_m - f)/v_S) \qquad (26)$$

Interpretiert man die Ergebnisse für das Ausgangssignal des Auflösungfilters 2 in Gleichung (22) für den Zeitbereich und in Gleichung (26) für den Frequenzbereich im Hinblick auf die Erfüllung der Erfindungsaufgabe, so können folgende Feststellungen hinsichtlich des Erfüllungsgrades der Erfindungsaufgabe durch den erfindungsgemäßen Spektrumanalysator 1 getroffen werden:

Da das Ausgangssignal d(t) des Auflösungfilters 2 im Zeitbereich gemäß Gleichung (22) keine komplexen vom Zeitargument t abhängigen Terme aufweist, falls die Impulsantwort h(t) des Vorfilters 22 rein reell gestaltet ist, kann jedes beliebige Eingangsignal a(t) niemals durch das Auflösungfilter 2 zum Schwingen angeregt werden. Insofern ist die Bandbreite des Auflösungfilters 2, insbesondere die Bandbreite des zum Auflösungfilters 2 gehörigen Vorfilters 22, im Hinblick auf eine Dämpfung derart auftretender Schwingungen nicht zu erhöhen. Die mit dem Auflösungfilters 2 realisierte Auflösung des erfindungsgemäßen Spektrumanalysators 1 wird deshalb im Gegensatz zum Stand der Technik nicht unnötig reduziert.

Hinzukommt, dass der Phasenfaktor exp $(j\pi f^2/v_s)$ des Ausgangssignal d $(f_m)$ des Auflösungfilters 2 in Frequenzbereich von der Meßfrequenz $f_m$ unabhängig ist. Liegen nämlich zwei Spektrallinien eines analysierenden Eingangsignals a(t) hinsichtlich ihres Frequenzabstandes so nahe beieinander, dass bei gegebener Auflösungsbandbreite des Auflösungfilters 2 die durch die Vorfilterung und anschließende Faltung mittels Auflösungsfilter 2 resultierenden Frequenzspektren der beiden Spektrallinien sich in einem gewissen Frequenzbereich überlappen, so kann es in diesem überlappenden Frequenzbereich zu Mitkopplung führenden Phasenüberlagerungen der Phasenfaktoren in den Frequenzspektren der beiden Spektrallinien kommen.

Aus Gleichung (26) erkennt man, dass ein mit fester Frequenz f schwingendes Eingangsignal a(t) am Ausgang des Korrelators 23 bezüglich der Meßfrequenz $f_m$ verbreitert wird. Diese frequenzmäßige Verbreiterung wird einerseits durch die zeitliche Länge $\Delta t_{VF}$ der Impulsantwort h(t) des Vorfilters 22 und andererseits durch die Sweep-Geschwindigkeit $v_s$, die im Argument der Impulsantwort h zu einer Division der Meßfrequenz $f_m$ führt, bestimmt. Um eine frequenzmäßige Verbreiterung des Eingangsignal a(t) am Ausgang des Korrelator 23 im Hinblick auf eine möglichst hohe Auflösung $B_A$ des erfindungsgemäßen Spektrumanalysators 1 weitestgehend zu minimieren, ist die Impulsantwort h(t) des Vorfilters 22 im Zeitbereich bezüglich ihrer zeitliche Länge $\Delta t$ möglichst kurz zu gestalten, was mit einer Erhöhung der Bandbreite $\Delta f_{VF}$ der korrespondierenden Übertragungsfunktion H(f) des Vorfilters 22 in Frequenzbereich verbunden ist.

Im Gegensatz zum Stand der Technik, in dem eine hohe Auflösung $B_A$ des Spektrumanalysators durch Schmalbandigkeit des Auflösungfilters erzielt wird, wird eine hohe Auflösung $B_A$ des erfindungsgemäßen Spektrumanalysators 1 durch eine möglichst kurze Impulsantwort h(t) des Vorfilters 22 im Zeitbereich und damit korrelierend eine hohe Bandbreitigkeit der Übertragungsfunktion H(f) des Vorfilters 22 im Frequenzbereich gewonnen. Die maximale Bandbreite des Vorfilters 22 ist aber durch die maximale Abtastrate eines im erfindungsgemäßen Spektrumanalysator 1 integrierten Analog-Digital-Wandlers und durch die Bandbreite der analog realisierten Filterkomponente des Vorfilters 22 nach oben begrenzt.

Eine zusätzliche frequenzmäßige Verbreiterung des Eingangsignals a(t) am Ausgang des Korrelator 23 im Hinblick auf eine möglichst hohe Auflösung $B_A$ des erfindungsgemäßen Spektrumanalysator 1 kann nur noch durch Verkleinerung der Sweep-Geschwindigkeit $v_s$ gewonnen werden. Im Gegensatz zum Spektrumanalysator der Stand der Technik verhalten sich die Bandbreite $B_{RES}$ des Auflösungfilters und die Sweep-Geschwindigkeit $v_s$ des Spektrumanalysators nicht mehr gegenläufig. Insofern muss eine Minimierung des K-Faktors beim erfindungsgemäßen Spektrumanalysator 1 nicht mehr angestrebt werden. Die Auflösungsbegrenzung des erfindungsgemäßen Spektrumanalysators 1 ist vielmehr durch die nach oben begrenzte Abtastfrequenz des Analog-Digital-Wandlers und durch die nach oben begrenzte Bandbreite $B_{RES}$ der analog realisierten Filterkomponente des Vorfilters 22 bestimmt.

In Fig. 3 ist eine zweite Ausführungsform eines erfindungsgemäßen Auflösungfilters 2' in einem erfindungsgemäßen Spektrumanalysator 1 dargestellt. Gleiche Elemente der zweiten Ausführungsform des erfindungsgemäßen Auflösungfilters 2 werden mit gleichen Bezugszeichen dargestellt und im einzelnen nicht mehr erklärt.

Im Gegensatz zur ersten Ausführungsform des erfindungsgemäßen Auflösungfilters wird das analoge Vorfilters 22 mit der Übertragungsfunktion H(f) in eine analoge Filterkomponente 25 mit Übertragungsfunktion $H_1(f)$, die sich an den Mischer 20 anschließt, einen daran anschließenden Analog-Digital-Wandlers 25 zur Analog-Digital-Wandelung des in der analogen Filterkomponente 25 vorgefilterten Basisbandssignals b(t) und einer daran anschließenden digitalen Filterkomponente 26, die als nicht-rekursives digitales Filter (FIR-Filter) mit der Übertragungsfunktion $H_2(z)$ ausgeführt ist, zerlegt. Auf diese Weise kann die digitale Filterkomponente 26 und der digital realisierte Korrelator 23 in einem einzigen integrierten Baustein aufwandsminimiert realisiert werden.

Die Nicht-Rekursivität der digitalen Filterkomponente 26 ist zwingende Voraussetzung zur Verwirklichung eines zeitlich begrenzten vorgefilterten Basisbandssignals c(k), um den Rechenaufwand der digitalen Faltung des zeitdiskreten vorgefilterten Basisbandssignals c(k) mit der zeitdiskreten Korrekturfunktion g(k) im Korrelator 23 in einem realistischen Größenbereich zu beschränken.

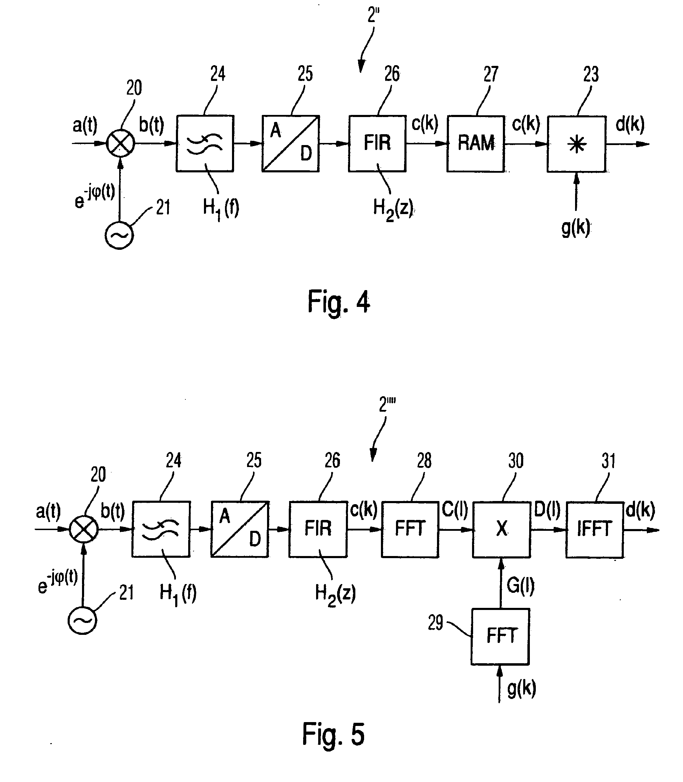

In Fig. 4 ist eine dritte Ausführungsform eines erfindungsgemäßen Auflösungfilters 2" in einem erfindungsgemäßen Spektrumanalysator 1 dargestellt.

Hierbei wird in Abgrenzung zur zweiten Ausführungsform des erfindungsgemäßen Auflösungfilters 2' des erfindungsgemäßen Spektrumanalysators 1 im Anschluss an die digitale Filterkomponente 26 ein digitaler Speicherbaustein (RAM) 27 eingeführt, in dem die digitale Filterkomponente 26 die Abtastwerte des vorgefilterten Basisbandssignals c(k) im Takt der Abtastfrequenz in Echtzeit abspeichert. Aus diesem digitalen Speicherbaustein 27 liest der digital realisierte Korrelator 23 vollkommen zeitasynchron zur Echtzeitfilterung des Vorfilters 24 und 26 die abgespeicherten Abtastwerte des vorgefilterte Basisbandsignals c(k) aus, um sie im Offline-Betrieb mit der zeitdiskreten Korrekturfunktion g(k) zu falten.

In Fig. 5 ist eine vierte Ausführungsform eines erfindungsgemäßen Auflösungfilters 2''' in einem erfindungsgemäßen Spektrumanalysator 1 dargestellt. Im Gegensatz zur zweiten Ausführungsform eines erfindungsgemäßen Auflösungfilters 2' in Fig. 3 wird anstelle einer sehr rechenaufwändigen Faltung des Korrelators 23 im Zeitbereich eine weniger aufwändige Multiplikation im Frequenzbereich durchgeführt.

Hierzu wird das zeitdiskrete vorgefilterte Basisbandsignal c(k) in einer Einheit 28 zur Durchführung einer Fourier-Transformation, die laufzeitoptimierte Algorithmen zur Durchführung einer Fast-Fourier-Transformation beinhaltet, in den Frequenzbereich zur Bildung der korespondierenden Fourier-Transformierten C(1) transformiert. Analog wird die zeitdiskrete Korrekturfunktion g(k) in einer Einheit 29 zur Durchführung einer Fourier-Transformation in den Frequenzbereich zur Bildung der korrespondierenden Fourier-Transformierten G(1) transformiert. Aus den beiden Fourier-Transformierten C(1) und G(1) wird über einen komplexen Multiplizierer 30 die Fourier-Transformierte D(1) des Ausgangsignals d(k) des erfindungsgemäßen Auflösungfilters 2'''' berechnet.

Anschließend erfolgt mit einer Einheit 31 zur Durchführung einer inversen Fourier-Transformation eine Berechnung des zeitdiskreten Ausgangsignals des erfindungsgemäßen Auflösungfilters 2'''' aus der Fourier-Transformierten D(1). Unter der Annahme einer rechenoptimierten Durchführung der Algorithmen der Fast-Fourier-Transformation bzw. der inversen Fast-Fourier-Transformation in den Einheiten 28, 29 und 30 und einer im Vergleich zur digitalen Faltung in der zweiten und dritten Ausführungsform des erfindungsgemäßen Auflösungfilters 2' und 2" wesentlich einfacheren digitalen Multiplikation stellt die vierte Ausführungsform des erfindungsgemäßen Auflösungfilters 2'''' eine rechen- und laufzeitoptimierte Lösung zur Realisierung eines erfindungsgemäßen Auflösungsfilters dar.

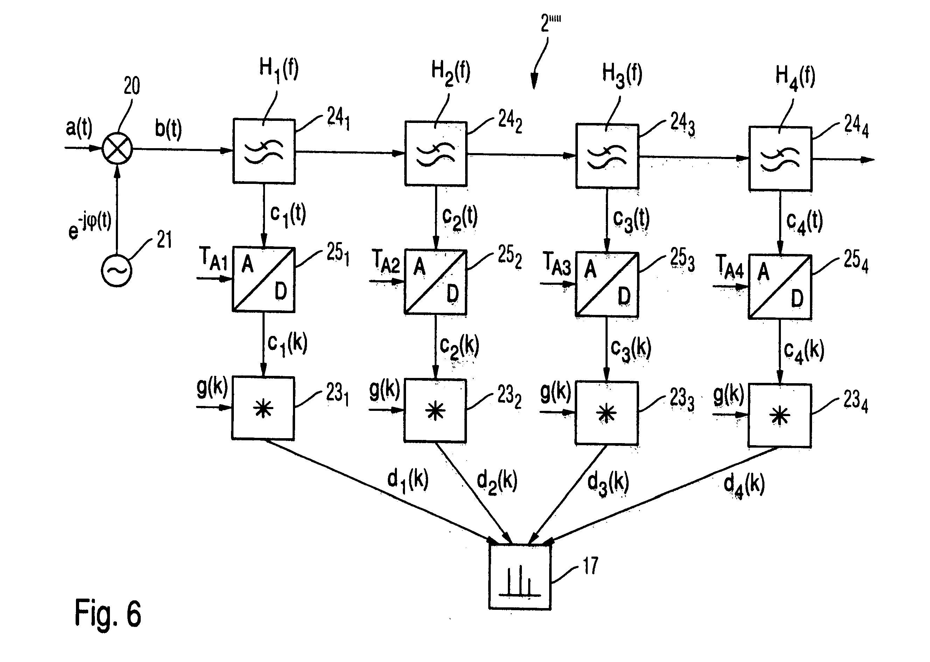

In Fig. 6 ist eine fünfte Ausführungsform eines erfindungsgemäßen Auflösungfilters 2''''' in einem erfindungsgemäßen Spektrumanalysator 1 dargestellt.

In der fünften Ausführungsform eines erfindungsgemäßen Auflösungfilters 2''''' in einem erfindungsgemäßen Spektrumanalysator 1 ist die analoge Filterkomponente 24 des Vorfilters 22 in mehrere, im dargestellten Beispiel in Fig. 6 in insgesamt vier, in Serie geschaltete analoge Filterkomponenten $24_1$, $24_2$, $24_3$ und $24_4$ unterteilt. Diese in Serie geschalteten analogen Filterkomponenten $24_1$, $24_2$, $24_3$ und $24_4$ stellen jeweils Tiefpaß-Filter mit unterschiedlicher Bandbreite dar. Auf diese Weise kann mit jeder dieser analogen Filterkomponenten $24_1$, $24_2$, $24_3$ und $24_4$ ein unterschiedlich großer Frequenzbereich innerhalb des gesamten Eingangsfrequenzbereichs des Basisbandssignals b(t) mittels Vorfilterung selektiert werden.

Auf Grund der dabei erzielten unterschiedlichen Bandbreiten der vorgefilterten Basisbandssignale $c_1(t)$, $c_2(t)$, $c_3(t)$ und $c_4(t)$ an den jeweiligen Ausgängen der analogen Filterkomponenten $24_1$, $24_2$, $24_3$ und $24_4$ können diese in jeweils nachfolgenden Analog-Digital-Wandlern $25_1$, $25_2$, $25_3$ und $25_4$ mit jeweils korrespondierenden unterschiedlichen Abtastraten $T_{A1}$, $T_{A2}$, $T_{A3}$ und $T_{A4}$ abgetastet werden (Nyquist-Kriterium). Die zeitdiskreten vorgefilterten Basisbandssignale $c_1(k)$, $c_2(k)$, $c_3(k)$ und $c_4(k)$ werden jeweils in den digitalen Korrelatoren $23_1$, $23_2$, $23_3$ und $23_4$ mit der zeitdiskreten Korrekturfunktion g(k) gefaltet, wobei diese digitalen Korrelatoren $23_1$, $23_2$, $23_3$ und $23_4$ auf Grund der unterschiedlichen Abtastfrequenzen $T_{A1}$, $T_{A2}$, $T_{A3}$ und $T_{A4}$ der zeitdiskreten vorgefilterten Basisbandsignale $c_1(k)$, $c_2(k)$, $c_3(k)$ und $c_4(k)$ mit unterschiedlicher Abtastrate arbeiten.

Der Korrelator $23_1$, der das zeitdiskrete vorgefilterte Basisbandsignal $c_1(k)$ mit der größten Bandbreite faltet, führt aufgrund der höchsten Abtastrate $T_{A1}$ am häufigsten die Faltung durch und der Korrelator $23_4$, der das zeitdiskrete vorgefilterte Basisbandsignal $c_4(k)$ mit der kleinsten Bandbreite faltet, führt auf Grund der niedrigsten Abtastrate $1/T_{A4}$ am wenigsten die Faltung durch. Wird der Korrelator $23_1$ dagegen in einer niedrigeren als der maximal möglichen Abtastfrequenz $1/T_{A1}$ betrieben, so erzielt man ein Ergebnis mit einer geringeren Auflösung. Auf diese Weise kann mit dem Vorfilter $24_1$ und dem Korrelator $23_1$ beispielsweise der gesamten Eingangsfrequenzbereich des Basisbandssignals b(t) mit einer geringeren Auflösung gemessen werden.

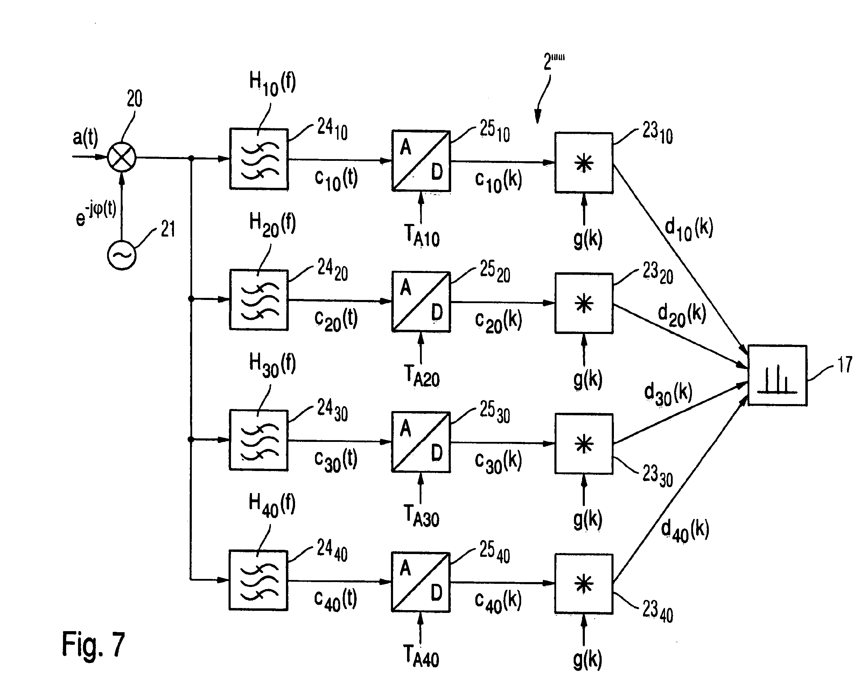

In Fig. 7 ist eine sechste Ausführungsform eines erfindungsgemäßen Auflösungfilters 2'''''' in einem erfindungsgemäßen Spektrumanalysator 1 dargestellt.

In der sechsten Ausführungsform eines erfindungsgemäßen Auflösungfilters 2'''''' in einem erfindungsgemäßen Spektrumanalysator 1 ist die analoge Filterkomponente 24 des Vorfilters 22 in mehrere, im dargestellten Beispiel in Fig. 7 in insgesamt vier, parallelgeschaltete analoge Filterkomponenten $24_{10}$, $24_{20}$, $24_{30}$ und $24_{40}$ aufgeteilt. Diese parallelgeschalteten analogen Filterkomponenten $24_{10}$, $24_{20}$, $24_{30}$ und $24_{40}$ stellen jeweils Bandpaß-Filter mit unterschiedlicher Mittenfrequenz und u. U. unterschiedlicher Bandbreite dar. Auf diese Weise kann mit jeder dieser analogen Filterkomponenten $24_{10}$, $24_{20}$, $24_{30}$ und $24_{40}$ ein bestimmtes Frequenzband innerhalb des gesamten Eingangsfrequenzbereichs des Basisbandssignals b(t) mit u. U. unterschiedlicher Frequenzbandbreite mittels Vorfilterung selektiert werden.

Auf Grund der dabei erzielten unterschiedlichen Bandbreiten der vorgefilterten Basisbandssignale $c_{10}(t)$, $c_{20}(t)$, $c_{30}(t)$ und $c_{40}(t)$ an den jeweiligen Ausgängen der analogen Filterkomponenten $24_{10}$, $24_{20}$, $24_{30}$ und $24_{40}$ können diese in jeweils nachfolgenden Analog-Digital-Wandlern $25_{10}$, $25_{20}$, $25_{30}$ und $25_{40}$ mit jeweils korrespondierenden unterschiedlichen Abtastraten $1/T_{A10}$, $1/T_{A20}$, $1/T_{A30}$ und $1/T_{A40}$ abgetastet werden (Nyquist-Kriterium). Die zeitdiskreten vorgefilterten Basisbandssignale $c_{10}(k)$, $c_{20}(k)$, $c_{30}(k)$ und $c_{40}(k)$ werden jeweils in den digitalen Korrelatoren $23_{10}$, $23_{20}$, $23_{30}$ und $23_{40}$ mit der zeitdiskreten Korrekturfunktion g(k) gefaltet, wobei diese digitalen Korrelatoren $23_{10}$, $23_{20}$, $23_{30}$ und $23_{40}$ auf Grund der unterschiedlichen Abtastfrequenzen $1/T_{A10}$, $1/T_{A20}$, $1/T_{A30}$ und $1/T_{A40}$ der zeitdiskreten vorgefilterten Basisbandssignale $c_{10}(k)$, $c_{20}(k)$, $c_{30}(k)$ und $c_{40}(k)$ mit unterschiedlicher Abtastrate arbeiten.

Schließlich kann die serielle Anordnungsstruktur der Vorfilter der fünften Ausführungsform eines erfindungsgemäßen Auflösungsfilters 2''''' mit der parallelen Anordnungsstruktur der Vorfilter der sechsten Ausführungsform eines erfindungsgemäßen Auflösungsfilters 2'''''' beliebig kombiniert werden. Auf diese Weise können mehrere Teilfrequenzbänder aus einer beliebigen Stelle des gesamten Eingangsfrequenzbereiches mit beliebiger Teilfrequenzbandbreite selektiert werden und mit unterschiedlicher Auflösung gleichzeitig in einer Anzeige 17 eines erfindungsgemäßen Spektrumanalysator 1 dargestellt werden. Insbesondere ist es möglich, einerseits den gesamten Eingangsfrequenzbereich mit einer geringeren Auflösung und andererseits gleichzeitig einen Teilfrequenzbereich, in dem sich mehrere Spektrallinien oder Peaks befinden, mit einer hohen Auflösung aufzuzeichnen und darzustellen.

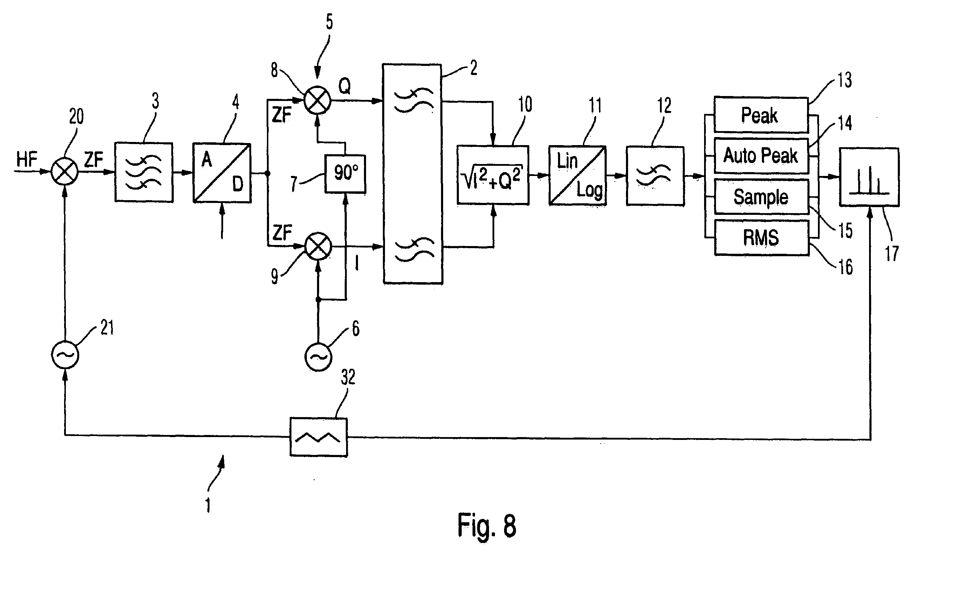

In Fig. 8 ist eine siebte Ausführungsform eines erfindungsgemäßen Spektrumanalysators 1' dargestellt, in der in Abgrenzung zur ersten Ausführungsform eines Spektrumanalysators 1 anstelle des Sägezahngenerators 18 ein Funktionsgenerator 32 mit einem dreiecksförmigen Zeitverlauf eingesetzt wird. Der Betrag der Steilheit der aufsteigenden und der absteigenden Flanke des dreiecksförmigen Zeitverlaufs sind unterschiedlich gestaltet. Auf diese Weise ist es möglich, den gesamten Eingangsfrequenzbereich des Eingangssignals a(t) sowohl mit der aufsteigenden als auch mit der abfallenden Frequenzrampe zu sweepen und aufgrund der unterschiedlichen Steilheit jeweils unterschiedliche Auflösungen der zu vermessenden Frequenzspektren zu erzielen.

Auf Grund von Linearitätsfehlern in gesteuerten Oszillatoren und Phasenregelkreisen kann es insbesondere bei den hohen Frequenzen im Bereich der oberen Grenzfrequenz des zu vermessenden Frequenzbandes zu Abweichungen zwischen der durch den Sägezahngenerator oder den dreiecksförmigen Funktionsgenerator vorgegebenen Sollfrequenz und der durch den Oszillator oder den Phasenregelkreis erzeugten Momentanfrequenz $f_M$ kommen. Da diese Linearitätsfehler insbesondere bei hoher Sweep-Geschwindigkeit und/oder hoher Auflösung nicht akzeptabel sind, müssen diese beseitigt werden, indem beispielsweise die digitale Frequenzteilung des Phasenistwertes am Eingang des Phasenreglers mit einem bestimmten Frequenzteilungswert nicht in gleichen Zeitabständen erfolgt, sondern die bei auftretenden Linearitätsfehlern für eine lineare Frequenzrampe erforderlichen optimierten Zeitabstände zum Schalten der Frequenzteilungswerte durch Kalibrierung ermittelt werden und anschließend beim Schalten der Frequenzteilungswerte benutzt werden.

Die Erfindung ist nicht auf die dargestellten Ausführungsformen beschränkt. Insbesondere können alle Merkmale aller Ausführungsformen vorteilhaft miteinander kombiniert werden.

**Patentansprüche**

1. Spektrumanalysator (1), der nach dem Überlagerungsprinzip arbeitet, mit einem Sollfrequenzgeber (18, 32), einem lokalen Frequenzoszillator (21), einem Mischer (20), einem Auflösungsfilter (2; 2'; 2''; 2'''; 2''''; 2''''') und einem Detektor (13, 14, 15, 16),
   **dadurch gekennzeichnet,**
   **daß** das Auflösungsfilter (2; 2'; 2''; 2'''; 2''''; 2''''') mehrere Vorfilter ($24_1$, $24_2$, $24_3$, $24_4$; $24_{10}$, $24_{20}$. $24_{30}$, $24_{40}$) mit jeweils von der Sweepgeschwindigkeit $v_s$ des Spektrumanalysators (1) unabhängigen Impulsantworten $h_i(t)$ unterschiedlicher Zeitdauer $\Delta t_{VFi}$ zur gleichzeitigen Vermessung des gesamten Frequenzbereiches und/oder eines oder mehrerer Teilfrequenzbereiche eines zu vermessenden Eingangssignals a(t) mit jeweils unterschiedlicher Auflösebandbreite aufweist, die in Reihe oder parallel geschaltet sind und deren Ausgänge über jeweils einen zugehörigen Analog-Digital-Wandler ($25_1$, $25_2$, $25_3$, $25_4$; $25_{10}$, $25_{20}$, $25_{30}$, $25_{40}$) mit jeweils einem zugehörigen Korrelator ($23_1$, $23_2$, $23_3$, $23_4$; $23_{10}$, $23_{20}$, $23_{30}$, $23_{40}$) verbunden sind.

2. Spektrumanalysator nach Anspruch 1,
   **dadurch gekennzeichnet,**
   **daß** der Korrelator (23) eine von der Sweepgeschwindigkeit $v_s$ des Spektrumanalysators (1) abhängige Korrekturfunktion g(t) als Funktion der Zeit t zur Faltung des im Vorfilter (22; 24, 26) vorgefilterten Eingangssgnals a(t) aufweist.

3. Spektrumanalysator nach Anspruch 2,
   **dadurch gekennzeichnet,**
   **daß** die Korrekturfunktion g(t) sich nach folgender Gleichung berechnet:

$$g(t) \; = \; e^{j2\pi \cdot v_s/2 \cdot t^2} \; .$$

4. Spektrumanalysator nach einem der Ansprüche 1 bis 3,
   **dadurch gekennzeichnet,**
   **daß** das Vorfilter (22; 24, 26) einen analogen Filteranteil (24) und einen sich anschließenden digitalen Filteranteil (26) umfaßt.

5. Spektrumanalysator nach Anspruch 4,
   **dadurch gekennzeichnet,**
   **daß** der digitale Filteranteil (24) des Vorfilters (22; 24, 26) ein nicht rekursives digitales Filter enthält, das in den Korrelator (23) integriert ist.

6. Spektrumanalysator nach einem der Ansprüche 1 bis 5,
   **dadurch gekennzeichnet,**
   **daß** der Korrelator (23) mit Algorithmen zur Durchführung der Fast-Fourier-Transformation realisiert ist.

7. Spektrumanalysator nach einem der Ansprüche 1 bis 6,
   **dadurch gekennzeichnet,**

**daß** das Vorfilter (22; 24, 26) und der Korrelator (23) quasi-parallel in Echtzeit arbeiten.

8.  Spektrumanalysator nach einem der Ansprüche 1 bis 6,
    **dadurch gekennzeichnet,**
    **daß** das Vorfilter (22; 24, 26) die vorgefilterten Abtastwerte c(k) der Eingangsfunktion a(t) in Echtzeit in einem digitalen Speicher (27) abspeichert, welche der Korrelator (23) asynchron zur zeitversetzten Faltung ausliest.

9.  Spektrumanalysator nach einem der Ansprüche 1 bis 8,
    **dadurch gekennzeichnet,**
    **daß** der Sollfrequenzgeber (18; 32) ein Sägezahngenerator ist, der eine Frequenzrampe zur Ansteuerung des Frequenzoszillators (21) über den gesamten zu vermessenden Frequenzbereich des Eingangssignals a(t) erzeugt.

10. Spektrumanalysator nach einem der Ansprüche 1 bis 9,
    **dadurch gekennzeichnet,**
    **daß** die Abtastfrequenz $1/T_{Ai}$ des zugehörigen Analog-Digital-Wandlers ($25_1$, $25_2$, $25_3$, $25_4$; $25_{10}$, $25_{20}$, $25_{30}$, $25_{40}$) indirekt proportional zur Bandbreite $\Delta f_{VFi}$ der Impulsantwort $h_i(t)$ des Vorfilters ($24_1$, $24_2$, $24_3$, $24_4$; $24_{10}$, $24_{20}$, $24_{30}$, $24_{40}$) ist und der zugehörige Korrelator ($23_1$, $23_2$, $23_3$, $23_4$; $23_{10}$, $23_{20}$, $23_{30}$, $23_{40}$) mit der Abtastfrequenz $1/T_{Ai}$ des zugehörigen Analog-Digital-Wandlers ($25_1$, $25_2$, $25_3$, $25_4$; $25_{10}$, $25_{20}$, $25_{30}$, $25_{40}$) die Faltung des im Vorfilter ($24_1$, $24_2$, $24_3$, $24_4$; $24_{10}$, $24_{20}$, $24_{30}$, $24_{40}$) vorgefilterten Eingangssignals a(t) durchführt.

11. Spektrumanalysator nach einem der Ansprüche 1 bis 10,
    **dadurch gekennzeichnet,**
    **daß** der Sollfrequenzgeber (18; 32) durch einen Funktionsgenerator zur Erzeugung einer dreiecksförmigen Zeitfunktion (32) realisiert ist, deren aufsteigende und absteigende Frequenzrampe unterschiedliche Steigung aufweist und zur Ansteuerung des Frequenzoszillators (21) jeweils über den gesamten zu vermessenden Frequenzbereich des Eingangssignals a(t) dient.

12. Auflösungsfilter (2; 2'; 2''; 2'''; 2''''; 2'''''; 2'''''') für einen Spektrumanalysator (1),
    **dadurch gekennzeichnet,**
    **daß** das Auflösungsfilter (2; 2'; 2''; 2'''; 2''''; 2'''''; 2'''''') mehrere Vorfilter ($24_1$, $24_2$, $24_3$, $24_4$; $24_{10}$, $24_{20}$, $24_{30}$, $24_{40}$) mit jeweils von der Sweepgeschwindigkeit $v_s$ des Spektrumanalysators (1) unabhängigen Impulsantworten $h_i(t)$ unterschiedlicher Zeitdauer $\Delta t_{VFi}$ zur gleichzeitigen Vermessung des gesamten Frequenzbereiches und/oder eines oder mehrerer Teilfrequenzbereiche eines zu vermessenden Eingangssignals a(t) mit jeweils unterschiedlicher Auflösebandbreite aufweist, die in Reihe oder parallel geschaltet sind und deren Ausgänge über jeweils einen zugehörigen Analog-Digital-Wandler ($25_1$, $25_2$, $25_3$, $25_4$; $25_{10}$, $25_{20}$, $25_{30}$, $25_{40}$) mit jeweils einem zugehörigen Korrelator ($23_1$, $23_2$, $23_3$, $23_4$; $23_{10}$, $23_{20}$, $23_{30}$, $23_{40}$) verbunden sind.

13. Auflösungsfilter nach Anspruch 12,
    **dadurch gekennzeichnet,**
    **daß** der Korrelator (23) eine von der Sweepgeschwindigkeit $v_s$ des Spektrumanalysators (1) abhängige Korrekturfunktion g(t) als Funktion der Zeit t zur Faltung des im Vorfilter (22; 24, 26) vorgefilterten Eingangssignals a(t) aufweist.

14. Auflösungsfilter nach Anspruch 13,
    **dadurch gekennzeichnet,**
    **daß** die Korrekturfunktion g(t) sich nach folgender Gleichung berechnet:

$$g(t) \;=\; e^{j2\pi \cdot v_S/2 \cdot t^2} \, .$$

Fig. 1

EP 1 788 399 A2

Fig. 2

Fig. 3

Fig. 4

Fig. 5

Fig. 6

Fig. 7

EP 1 788 399 A2

Fig. 8

EP 1 788 399 A2

## IN DER BESCHREIBUNG AUFGEFÜHRTE DOKUMENTE

### In der Beschreibung aufgeführte Patentdokumente

- DE 10105258 A1

### In der Beschreibung aufgeführte Nicht-Patentliteratur

- **CHRISTOPH RAUSCHER.** Grundlagen der Spektrumsanalyse. *Rohde und Schwarz GmbH & Co. KG,* 2000, 19-28

- **CHRISTOPH RAUSCHER.** Grundlagen der Spektrumsanalyse. *Rohde und Schwarz GmbH & Co. KG,* 2000, 29-32